# EUROPEAN PATENT APPLICATION

(11) **EP 4 760 986 A1**
(43) Date of publication of application: **17.06.2026**
(21) Application number: 24854271.4
(22) Date of filing: 04.06.2024
(51) Int. Cl.: H01Q 3/24, H01Q 1/50, H01Q 1/02, H01Q 1/32, H05K 1/02, H01Q 1/48, H01Q 21/00, H04M 1/02

(54) **DIRECTIONAL VARIABLE ANTENNA DEVICE AND OPERATING METHOD THEREOF**

(30) Priority: 14.08.2023 KR 20230106465; 05.10.2023 KR 20230132510
(71) Applicant: Samsung Electronics Co., Ltd., Suwon-si, Gyeonggi-do 16677 (KR)
(72) Inventor: SUNG, Sangbong, Suwon-si, Gyeonggi-do 16677 (KR); KIM, Jinu, Suwon-si, Gyeonggi-do 16677 (KR); SHIN, Yongsun, Suwon-si, Gyeonggi-do 16677 (KR); BAEK, Houn, Suwon-si, Gyeonggi-do 16677 (KR)
(74) Representative: Gulde & Partner
(86) International application number: PCT/KR2024/007649
(87) International publication number: WO 2025/037718

(57) **Abstract**

A directional variable antenna device is disclosed. The directional variable antenna device comprises a patch-type first antenna element to which a feed signal is applied, a patch-type second antenna element to which a ground signal is applied, and disposed to be spaced apart from the first antenna element, and a third antenna element disposed to be spaced apart from the first and second antenna elements.

## Description

### Technical Field

The disclosed embodiment relates to a vehicle antenna device and an operating method thereof, and more particularly, to a vehicle antenna device capable of changing directivity and an operating method thereof.

### Background Art

Recently, provision of various communication services and multimedia services to vehicles has increased. With the development of autonomous vehicles, there is an increasing need for communication technology that enables continuous communication with roadside infrastructure and vehicles as well as exchange or sharing of information about traffic conditions.

A vehicle may use antennas to transmit and/or receive a radio frequency (RF) signal including a voice signal or data (e.g., a message, a photograph, a video, a music file, or a game).

### Disclosure of Invention

### Technical Problem

As camping, travel, and outdoor activities using vehicles increases, the movement of users or vehicles tends to increase even in areas where existing terrestrial networks are not available.

Communication needs to be available even in areas where communication services through base stations are not provided.

### Solution to Problem

A vehicle antenna device or a directional variable antenna device according to a disclosed embodiment may include a patch-type first antenna element 331 to which a feed signal is applied.

The vehicle antenna device or the directional variable antenna device according to an embodiment may include a patch-type second antenna element 332 to which a ground signal is applied, and spaced apart from the first antenna element 331.

The vehicle antenna device or the directional variable antenna device according to an embodiment may include a third antenna element 333 spaced apart from the first and second antenna elements 331 and 332.

The vehicle antenna device or the directional variable antenna device according to an embodiment may form a first directional radiation pattern when an electrical signal is not applied to the third antenna element 333.

The vehicle antenna device or the directional variable antenna device according to an embodiment may form a second directional radiation pattern different from the first directional radiation pattern when a ground signal is applied to the third antenna element 333.

An operating method of a vehicle antenna device or a directional variable antenna device including the first antenna element 331, the second antenna element 332, and the third antenna element 333 according to an embodiment may include performing communication through a first network by applying a feed signal to the first antenna element 331 and applying a ground signal to the second antenna element 332.

The operating method of the vehicle antenna device or the directional variable antenna device including the first antenna element 331, the second antenna element 332, and the third antenna element 333 according to an embodiment may include performing communication through a second network by applying a feed signal to the first antenna element 331 and a ground signal to the second antenna element 332 and the third antenna element 333 when communication through the first network is impossible.

### Brief Description of Drawings

FIG. 1 is a diagram illustrating a vehicle in which an antenna device is installed, according to a disclosed embodiment.
FIG. 2 is a block diagram illustrating a vehicle electronic device including antenna devices, according to an embodiment.
FIG. 3 is a block diagram illustrating an antenna device according to an embodiment.
FIG. 4 is a plan view illustrating a first antenna element and a second antenna element, according to an embodiment.
FIG. 5A is a top plan view of an antenna device according to an embodiment.
FIG. 5B is a cross-sectional view of the antenna device of FIG. 5A.
FIG. 6 is a flowchart illustrating a method of operating an antenna device, according to an embodiment.
FIG. 7A is a photograph of a manufactured antenna device according to an embodiment.
FIG. 7B illustrates results of simulating a radiation pattern when an electrical signal is not applied to a third antenna element, according to an embodiment.
FIG. 7C illustrates results of simulating a radiation pattern when a ground signal is applied to the third antenna element.
FIG. 8 is a diagram illustrating an antenna device in which a third support member is disposed between a second antenna element and a third antenna element, according to an embodiment.
FIG. 9 is a diagram illustrating an antenna device in which a fourth support member is disposed between a chip module and a third antenna element, according to an embodiment.
FIG. 10 is a diagram illustrating a part of an antenna device including a dummy antenna element, according to an embodiment.
FIG. 11 is a diagram illustrating a part of an antenna device including a dummy antenna element, according to an embodiment.
FIG. 12 is a view illustrating first and second antenna elements including holes, according to an embodiment.
FIG. 13 is a diagram illustrating bent antenna elements according to an embodiment.
FIG. 14 is a block diagram illustrating a vehicle electronic device including an antenna device, according to an embodiment.
FIG. 15 is a flowchart illustrating a method of controlling driving of a vehicle by using an antenna device, according to an embodiment.

### Mode for the Invention

Embodiments of the present disclosure will now be described more fully with reference to the accompanying drawings for one of ordinary skill in the art to be able to perform the present disclosure without any difficulty. However, the present disclosure may be embodied in many different forms and is not limited to the embodiments set forth herein. For clarity, portions irrelevant to the descriptions of the present disclosure are omitted in the drawings, and like components are denoted by like reference numerals throughout the specification.

Throughout the specification, when a component is referred to as being "connected" to another component, it will be understood to include that the component is "directly connected" to the other component or is "electrically connected" to the other component with another component therebetween. When a part "includes" an element, another element may be further included, rather than excluding the existence of the other element, unless otherwise described.

The expression "in some embodiments" or "in an embodiment" appearing in various parts of the specification is not necessarily referring to the same embodiment of the specification.

Some embodiments may be represented by functional block components and various process operations. Some or all of functional blocks may be implemented by various numbers of hardware and/or software configurations for performing certain functions. For example, functional blocks of the present disclosure may be implemented by using one or more processors or microprocessors, or circuit elements for intended functions. In addition, for example, the functional blocks may be implemented in various programing or scripting languages. The functional blocks may be implemented in an algorithm executed by one or more processors. In addition, the present disclosure may employ related-art techniques for electronic configuration, signal processing, and/or data processing, etc. Terms such as 'module' and 'component' may be used broadly and may not be limited to mechanical and physical elements.

In addition, connection lines or connection members between components illustrated in the drawings are merely illustrative of functional connections and/or physical or circuit connections. In an actual device, connections between components may be represented by various functional connections, physical connections, or circuit connections that are replaceable or added.

In addition, the expression 'at least one of a, b, and c' indicates only a, only b, only c, both a and b, both a and c, both b and c, or all of a, b, and c.

A vehicle, a vehicle electronic device, a vehicle antenna device, and an operating method of the vehicle antenna device according to a disclosed embodiment will be described in detail with reference to the attached drawings. In the attached drawings, the same elements are denoted by the same reference numerals. In addition, throughout the detailed description, the same elements are described with the same terms.

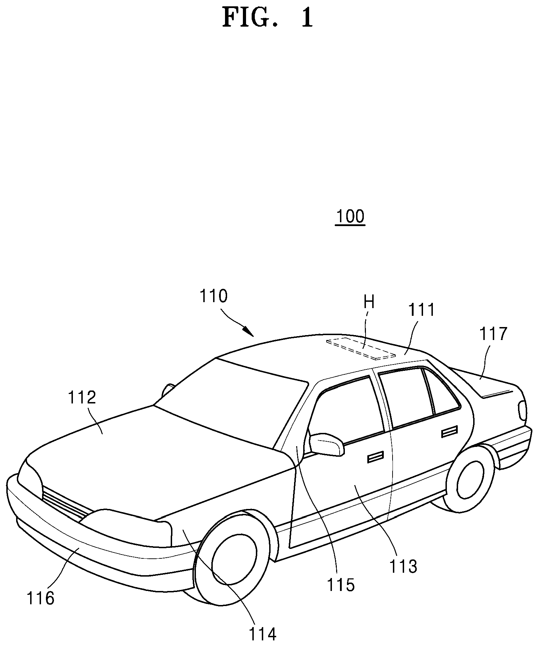

FIG. 1 is a view illustrating a vehicle 100 on which an antenna device is installed, according to a disclosed embodiment.

A vehicle antenna device according to a disclosed embodiment may be disposed outside or inside the vehicle 100. Referring to FIG. 1, the antenna device (not shown) may be installed in a region H of a panel that forms an outer shape of the vehicle 100. For example, the antenna device coupled to an upper panel 110 is disposed by opening a region of the upper panel 110. In addition, the region H may be an opening of the upper panel 110.

In addition, the antenna device is installed in one region H of an upper portion of the vehicle 100 in FIG. 1, but the antenna device may be installed anywhere inside or outside the vehicle 100.

For example, the antenna device (not shown) may be installed in a lower region or an inner region of at least one of a bonnet panel 112, a door panel 113, a fender panel 114, a pillar panel 115, a bumper panel 116, or a trunk panel 117 of the vehicle 100.

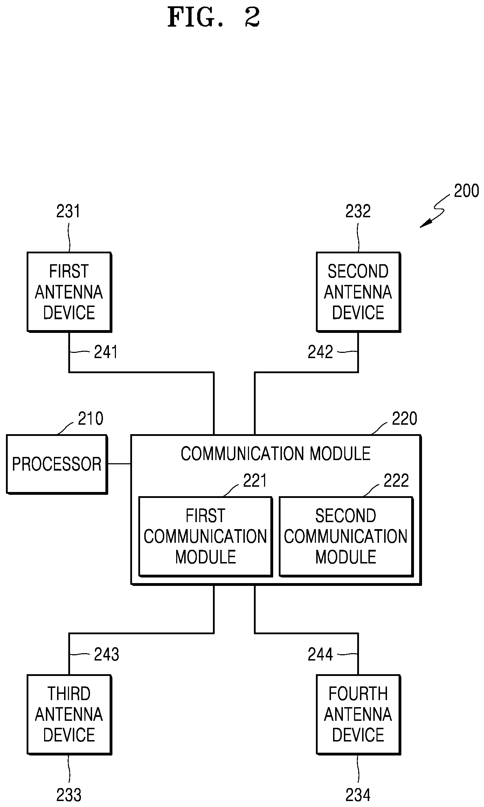

FIG. 2 is a block diagram illustrating a vehicle antenna device 200 including antenna devices according to an embodiment. Referring to FIG. 2, the electronic device 200 may include a processor 210, a communication module 220, one or more antenna devices 231, 232, 233, and 234, and one or more conductive lines 241, 242, 243, and 244.

According to an embodiment, the processor 210 may include one or more of a central processing unit, an application processor (AP), a graphics processing unit (GPU), or a baseband processor (BP) (or a communication processor (CP)). According to an embodiment, the processor 210 may be implemented as a system on chip (SoC) or a system in package (SiP).

The processor 210 may include internal memory (not shown) and at least one processor (not shown) executing at least one stored program. Here, the internal memory (not shown) of the processor 210 may store one or more instructions. Then, the processor 210 may execute a predetermined operation by executing at least one of the one or more instructions stored in the internal memory (not shown).

For example, the processor 210 may include random-access memory (RAM) storing signals or data input from outside or used as a storage region corresponding to various tasks performed by the antenna devices 231, 232, 233, and 234, read-only memory (ROM) (not shown) storing a control program and/or a plurality of instructions for controlling the antenna devices 231, 232, 233, and 234, and/or at least one processor (not shown).

Alternatively, the processor 210 may be implemented as an SoC in which a core (not shown) and a GPU (not shown) are integrated. Alternatively, the processor 210 may include a multi-core greater than a single core. For example, the processor 210 may include a dual core, a triple core, a quad core, a hexa core, an octa core, a deca core, a dodeca core, or a hexadecimal core.

The processor 210 may include components (e.g., an AP and memory) for implementing a hardware platform and components (e.g., an operating system (OS) program, automotive safety software, and an application) for implementing a software platform.

At least one of the operations performed by the processor 210 may be performed using artificial intelligence (AI) technology.

According to an embodiment, the communication module 220 may support establishment of a communication channel between the electronic device 200 and an external device and communication through the established communication channel. The communication module 220 may include one or more communication processors that operate independently of a processor (e.g., AP) and support communication.

According to an embodiment, the communication module 220 may communicate with an external electronic device through a short-distance communication network (e.g., Bluetooth, WiFi direct or infrared data association (IrDA)) or a long-distance communication network (e.g., cellular network, Internet, or computer network (e.g., LAN or WAN). Alternatively, the communication module 220 may communicate with the external electronic device through a non-terrestrial network (NTN).

The communication module 220 may be integrated into one component (e.g., a single chip), or may be implemented as a plurality of separate components (e.g., a plurality of chips).

The communication module 220 may be electrically connected to at least one of the first antenna device 231, the second antenna device 232, the third antenna device 233, or the fourth antenna device 234 by using at least one of the first conductive line 241, the second conductive line 242, the third conductive line 243, or the fourth conductive line 244. For example, the communication module 220 may be electrically connected to the first antenna device 231, the second antenna device 232, the third antenna device 233, and the fourth antenna device 234, by using the first conductive line 241, the second conductive line 242, the third conductive line 243, and the fourth conductive line 244, respectively.

The communication module 220 may include at least one of a BP, a radio frequency integrated circuit (RFIC), or an intermediate frequency integrated circuit (IFIC).

According to an embodiment, the communication module 220 may include a processor (e.g., BP) separate from the processor 210 (e.g., AP). For example, when the processor 210 includes an AP and the communication module 220 includes a BP, the electronic device 200 may further include an RFIC or an IFIC as a separate module (not shown). In this case, the RFIC or the IFIC may be electrically connected to the communication module 220, and may be electrically connected to the first antenna device 231, the second antenna device 232, the third antenna device 233, and the fourth antenna device 234 through the first conductive line 241, the second conductive line 242, the third conductive line 243, and the fourth conductive line 244, respectively.

For another example, a BP and an RFIC or an IFIC may be integrally formed into one communication module 220. According to another embodiment, the processor 210 includes an AP and a BP, and the communication module 220 may include an IFIC or an RFIC.

The first conductive line 241, the second conductive line 242, the third conductive line 243, and/or the fourth conductive line 244 may include, for example, a coaxial cable and/or a flexible printed circuit board (FPCB).

According to an embodiment, the communication module 220 may include at least one of a first communication module 221 (e.g., a first BP) or a second communication module 222 (e.g., a second BP). The electronic device 200 may further include at least one interface (e.g., inter-processor communication channel) for supporting chip-to-chip communication between the first communication module 221 (e.g., the first BP) or the second communication module 222 (e.g., the second BP) and the processor 210. The processor 210 and the first communication module 221 or the second communication module 222 may transmit or receive data by using the at least one interface.

According to an embodiment, the first communication module 221 or the second communication module 222 may provide an interface for performing communication with other entities. The first communication module 221 may support wireless communication with respect to, for example, a first network (not shown). The second communication module 222 may support wireless communication with respect to, for example, a second network (not shown).

According to an embodiment, the first communication module 221 or the second communication module 222 may form one module with the processor 210. For example, the first communication module 221 or the second communication module 222 may be integrally formed with the processor 210.

According to an embodiment, the communication module 220 may be formed as one communication module (e.g., a BP). For example, the communication module 220 may include one communication module capable of supporting wireless communication with respect to a network.

According to another embodiment, the first communication module 221 or the second communication module 222 may be disposed within one chip or may be formed in the form of an independent chip. According to an embodiment, the processor 210 and at least one BP (e.g., the first communication module 221) may be integrally formed in one chip (e.g., an SoC chip), and the other BP (e.g., the second communication module 222) may be formed in the form of an independent chip.

According to an embodiment, the first to fourth antenna devices 231, 232, 233, and 234 may up-convert or down-convert frequencies. For example, the first antenna device 231 may up-convert an intermediate frequency (IF) signal received through the first conductive line 241. For another example, the first antenna device 231 may down-convert a signal received through an antenna (not shown), and transmit the downconverted signal to the communication module 220 using the first conductive line 241.

According to an embodiment, the first to fourth antenna devices 231, 232, 233, and 234 may directly transmit signals to the processor 210 or receive signals from the processor 210 through the first to fourth conductive lines 241, 242, 243, and 244, respectively. For example, the communication module 220 may be omitted or integrated into the processor 210.

For example, operations of the communication module 220 described in the present disclosure may be performed by the processor 210 and/or the first to fourth antenna devices 231, 232, 233, and 234.

The processor 210 may monitor communication states of the first to fourth antenna devices 231, 232, 233, and 234. When data transmission and reception through a specific antenna element is not performed for a predetermined time, the processor 210 may determine that communication of the specific antenna element is impossible. It has been described that the processor 210 monitors a communication state of the antenna element, but the present disclosure is not limited thereto. The communication module 220 may monitor the communication state of the antenna element.

When communication is impossible, the processor 210 may operate a specific conductive material disposed adjacent to the antenna element as an antenna element by controlling a ground signal to be applied to the specific conductive material.

The vehicle electronic device 200 according to an embodiment may be disposed on one or more printed circuit boards (PCBs). A plurality of antenna elements 331, 332, 333, and 334, the communication module 220, and the processor 210 may be disposed on one PCB, or may be divided and disposed on a plurality of PCBs.

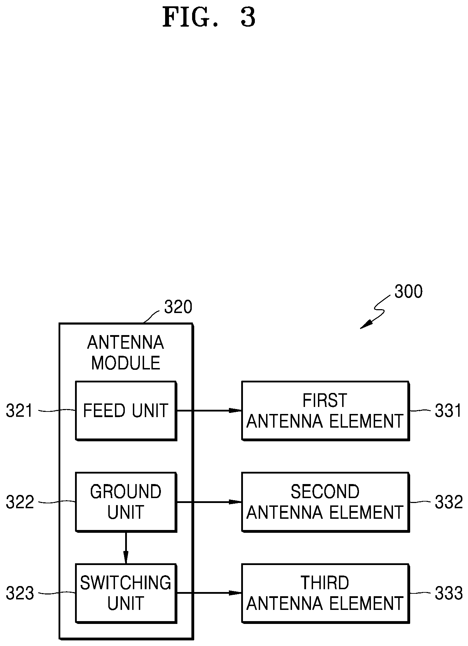

FIG. 3 is a block diagram illustrating an antenna device 300 according to an embodiment. The antenna device 300 may transmit or receive a signal with an external device through a wireless network. Referring to FIG. 3, the antenna device 300 may include an antenna module 320 (e.g., an RFIC), and one or more antenna elements (e.g., the first antenna element 331, the second antenna element 332, and/or the third antenna element 333). However, the present disclosure is not limited thereto. The antenna device 300 may further include at least some functions of the processor 210 and the communication module 220 described with reference to FIG. 2.

The antenna module 320 may be electrically connected to the one or more antenna elements 331, 332, and 333.

The antenna module 320 may include a radio frequency integrated circuit (hereinafter referred to as an 'RFIC') that processes radio signals and transmits or receives radio signals to or from an external device (e.g., a base station). However, the present disclosure is not limited thereto. The antenna module 320 may perform at least some functions of the processor 210 or the communication module 220 described above. For example, the antenna module 320 may further include at least one of a modem or an inter frequency integrated circuit (hereinafter referred to as an "IFIC").

There may be a plurality of antenna modules 320. According to an embodiment, the antenna module 320 may include a first antenna module (not shown) and a second antenna module (not shown). The first antenna module (not shown) and the second antenna module (not shown) may be set to control signal processing and/or transmission and reception of different frequency bands. For example, the first antenna module (not shown) may be set to control processing and/or transmission and reception of signals in a first frequency band, and the second antenna module (not shown) may be set to control processing and/or transmission and reception of signals in a second frequency band different from the first frequency band.

According to an embodiment, the first frequency band and the second frequency band may be different from each other in at least one of a range of a frequency band or a center frequency. For example, at least a part of the first frequency band may not overlap at least a part of the second frequency band. For another example, the first frequency band may not overlap the second frequency band.

The antenna module 320 may include a feed unit 321 applying a feed signal to the first antenna element 331, a ground unit 322 applying a ground signal to at least one of the second antenna element 332 or the third antenna element 333, and a switching unit 323 switching the ground signal to be turned on or off to the third antenna element 333. The switching unit 323 may include at least one of an inductor or a capacitor.

FIG. 3 illustrates that the antenna module 320 includes the ground unit 322 and the switching unit 323, but the present disclosure is not limited thereto. The ground unit 322 and the switching unit 323 may be disposed outside the antenna module 320, and the processor 210 may directly control the switching unit 323.

When the feed signal is applied to the first antenna element 331, and the ground signal is applied to the second antenna element 332, the first antenna element 331 and the second antenna element 332 may be electrically coupled to form a first directional radiation pattern. The antenna device 300 may perform wireless communication through a first network in the first directional radiation pattern. In this regard, the third antenna element 333 may be electrically open.

Meanwhile, when the feed signal is applied to the second antenna element 332, and the ground signal is applied to the second and third antenna elements 332 and 333, the first to third antenna elements 331, 332, and 333 may be electrically coupled to form a second directional radiation pattern. The antenna device 300 may perform wireless communication through a second network in the second directional radiation pattern.

The second directional radiation pattern may have a different directivity from the first directional radiation pattern, and the second network may be a network different from the first network. However, the present disclosure is not limited thereto. The second directional radiation pattern may have the same directivity as the first directional radiation pattern and may have a different center frequency from the first directional radiation pattern. Alternatively, the first directional radiation pattern and the second directional radiation pattern are transmitted and received through the same network, but may have different directivities.

The antenna module 320 may ground or electrically open the third antenna element 333 according to a communication state. The communication state may be divided into a communication impossible state in which a wireless signal may be transmitted and received through the first and second antenna elements 331 and 332, and a communication impossible state in which a wireless signal may not be transmitted and received through the first and second antenna elements 331 and 332. When data transmission and reception through the first and second antenna elements 331 and 332 are not performed for a predetermined time, the antenna module 320 may determine that communication is impossible.

For convenience of description, it has been described that communication is impossible when data transmission and reception through the first and second antenna elements 331 and 332 are not performed, but the present disclosure is not limited thereto. When data transmission and reception are not performed through all antenna elements disposed in a vehicle, communication may be impossible. Alternatively, when communication of a preset specific antenna element is impossible, communication may also be impossible. Here, the specific antenna element may be an antenna element capable of transmitting and receiving the same type of data as data transmitted and received through the first to third antenna elements 331, 332, and 333.

When communication is impossible, the switching unit 323 may electrically turn on the ground unit 322 and the third antenna element 333. Then, the antenna device 300 may transmit and/or receive wireless signals through the first to third antenna elements 331, 332, and 333.

For example, the antenna module 320 may form a radiation pattern by applying a feed signal to the first antenna element 331, applying a ground signal to the second and third antenna elements 332 and 333, and electrically coupling the first to third antenna elements 331, 332, and 333. The third antenna element 333 may be coupled to the first antenna element 331 through the second antenna element 332. For example, the third antenna element 333 may be electrically coupled to the second antenna element 332, and the second antenna element 332 may be electrically coupled to the first antenna element 331. However, the present disclosure is not limited thereto. The third antenna element 333 may be electrically coupled to the first and second antenna elements 331 and 332 at the same time.

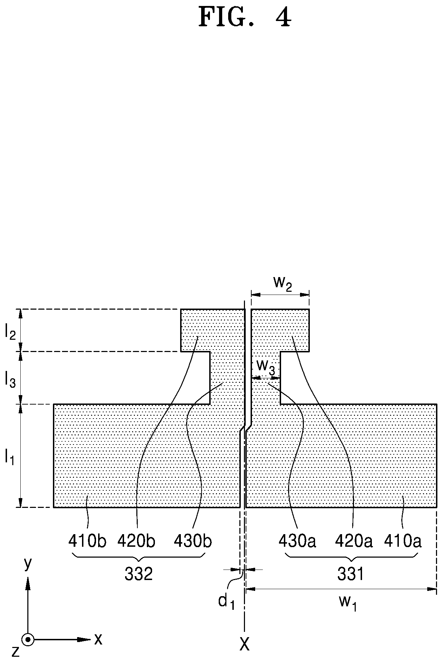

FIG. 4 is a plan view illustrating the first antenna element 331 and the second antenna element 332 according to an embodiment.

As shown in FIG. 4, the first and second antenna elements 331 and 332 may be patch-type. A patch-type antenna element may have an upper surface and/or a lower surface (hereinafter, referred to as a surface) greater than a thickness. The first and second antenna elements 331 and 332 may be coupled to be referred to as a dipole antenna. The surfaces of the first and second antenna elements 331 and 332 may be arranged to face the same direction. For example, the first antenna element 331 and the second antenna element 332 may be arranged in parallel in a first direction, for example, in a direction (e.g., a y-axis direction) perpendicular to a thickness direction of the second antenna element 332.

The first and second antenna elements 331 and 332 may be spatially spaced apart from each other. A separation distance d₁ of the first and second antenna elements 331 and 332 may be a distance at which the first antenna element 331 and the second antenna element 332 may be coupled. For example, the separation distance d₁ between the first and second antenna elements 331 and 332 may be about 5 mm or less.

The first and second antenna elements 331 and 332 may have a symmetrical structure. The first and second antenna elements 331 and 332 may be symmetrical with respect to a central axis X of the first and second antenna elements 331 and 332. Even when the similarity between the first and second antenna elements 331 and 332 is 80 % or more, the first and second antenna elements 331 and 332 may be referred to as having a symmetrical structure. This is because the structures of the first and second antenna elements 331 and 332 may be slightly different for adaptive impedance matching to an external environment.

The first antenna element 331 may include first to third regions 410a, 420a, and 430a having different numerical values. The dimensions of the first to third regions 410a, 420a, and 430a may respectively correspond to radio wave signals of a quarter wavelength that resonates in the first to third regions 410a, 420a, and 430a.

The first region 410a may have a first area, and the second region 420a may be spatially spaced apart from the first region 410a and may have a second area different from the first area. The third region 430a may be disposed between the first region 410a and the second region 420a, and may have a third area. One end of the third region 430a may be in contact with the first region 410a, and the other end thereof may be in contact with the second region 420a.

Each of the first to third regions 410a, 420a, and 430a may have a polygonal shape. However, the present disclosure is not limited thereto. Each of the first to third regions 410a, 420a, and 430a may have a polygonal, elliptical, circular, or modified shape thereof. Each of the first to third regions 410a, 420a, and 430a may have a length I and a width W within a similar range. For example, widths W₁, W₂, and W₃ with respect to lengths l₁, l₂, and l₃ of the first to third regions 410a, 420a, and 430a may be 0.5 to 2. That is, each of the first to third regions 410a, 420a, and 430a may be patch-type.

Meanwhile, the width W₃ of the third region 430a may be less than the width W₁ of the first region 410a and the width W₂ of the second region 420a. Thus, because the distinction between the first to third regions 410a, 420a, and 430a is clear, various frequency bands resonate in the antenna element 20, enabling the implementation of a broadband antenna device.

An operating frequency may vary depending on the lengths l₁, l₂, and l₃, the widths W₁, W₂, and W₃, etc. of the first to third regions 410a, 420a, and 430a.

The second antenna element 332 may also include first to third regions 410b, 420b, and 430b having different numerical values. The first region 410b may have a first area, and the second region 420b may be spatially spaced apart from the first region 410b and may have a second area. The third region 430b is disposed between the first region 410b and the second region 420b, and may have a third area. One end of the third region 430b may be in contact with the first region 410b, and the other end thereof may be in contact with the second region 420b. The second antenna element 332 has a symmetrical structure with respect to the first antenna element 331, and thus, a detailed description thereof is omitted.

Because the antenna element as described above includes regions of various dimensions, radio wave signals of various frequencies may resonate. For example, a radio signal may resonate in the first regions 410a and 410b, the second regions 420a and 420b, the third regions 430a and 430b, the sum of the first and third regions 410a, 410b, 430a and 430b, the sum of the second and third regions 420a, 420b, 430a and 430b, and the sum of the first to third regions 410a, 410b, 420a, 420b, 430a and 430b.

FIG. 4 illustrates that the first and second antenna elements 331 and 332 include three regions having different sizes, but the present disclosure is not limited thereto. Each of the first and second antenna elements 331 and 332 may include one region, and may include two regions having different sizes. Alternatively, each of the first and second antenna elements 331 and 332 may include four or more regions having different sizes. The shapes of the first and second antenna elements 331 and 332 may be designed based on a center frequency and a frequency band.

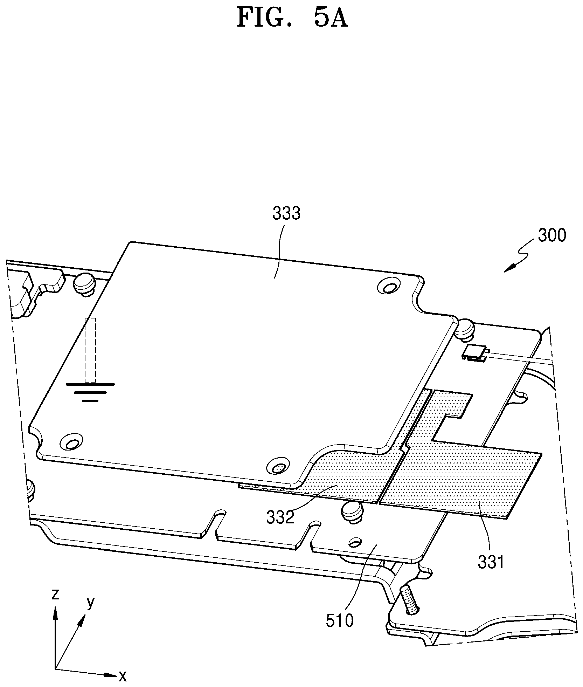

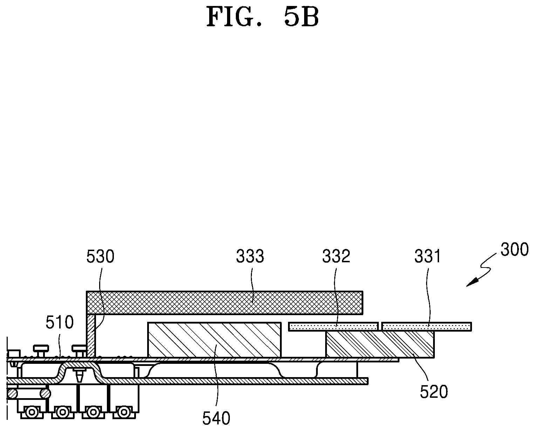

FIG. 5A is a top plan view of the antenna device 300 according to an embodiment. FIG. 5B is a cross-sectional view of the antenna device 300 of FIG. 5A.

As shown in FIGS. 5A and 5B, the first and second antenna elements 331 and 332 may be disposed on the PCB 510. The first and second antenna elements 331 and 332 are described with reference to FIG. 4, and thus, detailed descriptions thereof are omitted.

The PCB 510 may be a rigid PCB (RPCB), a flexible PCB (FPCB), or a rigid flexible PCB (RFPCB).

A first support member 520 may be disposed between the PCB 510 and the first and second antenna elements 331 and 332. The first support member 520 may include an insulating material. The first support member 520 may support the first and second antenna elements 331 and 332 so that the first and second antenna elements 331 and 332 are maintained on the PCB 510 at regular intervals. A plurality of conductive lines (not shown) may be disposed on the PCB 510. When the first and second antenna elements 331 and 332 form a radiation pattern, the first support member 520 may have a predetermined thickness or more so as not to be electrically coupled to the conductive line disposed in the PCB 510. For example, the thickness of the first support member 520 may be greater than about 5 mm.

When the surface of the PCB 510 is coated with an insulating material, and the first and second antenna elements 331 and 332 are not electrically coupled to the conductive material in the PCB 510, the first and second antenna elements 331 and 332 may be disposed in contact with the surface of the PCB 510.

The third antenna element 333 may be disposed on the second antenna element 332. The third antenna element 333 may be spaced apart from the second antenna element 332 to be electrically coupled. For example, the second antenna element 332 and the third antenna element 333 may be spaced apart from each other by about 5 mm or less.

The surfaces of the second antenna element 332 and the third antenna element 333 may be arranged to face the same direction as a first surface of the PCB 510. For example, the second antenna element 332 and the third antenna element 333 may be arranged in parallel in a second direction (z-axis direction), for example, in a thickness direction of the second antenna element 332, and a thickness direction of the PCB 510 and the thickness direction of the second antenna element 332 may be parallel.

The third antenna element 333 may overlap the second antenna element 332 in the thickness direction of the second antenna element 332, and may not overlap the first antenna element 331. More than half of the second antenna element 332 may overlap the third antenna element 333 in the thickness direction of the second antenna element 332. Thus, the third antenna element 333 and the second antenna element 332 may be easily electrically coupled.

The third antenna element 333 may be a heat sink dissipating heat to the outside. For example, the third antenna element 333 may be a vapor chamber, a cooling plate, etc. The vapor chamber may include a plurality of conductive plates that are thin and have a large surface area in the form of plates. The vapor chamber is a cooling system that repeats circulation while the state of an internal liquid continues to change through three wicks including a condensation wick, a vaporization wick, and a transportation wick. In other words, the vapor chamber may release heat generated from the PCB 510 or a chip module 540 that is described below to the outside (space in the opposite direction of the PCB 510 and the chip module 540) by circulating the internal liquid into gas and circulating the gas back into the liquid. On the other hand, because the vapor chamber includes a conductive material, only when an electrical signal is applied, the vapor chamber may operate as the third antenna element 333. When the cooling plate also includes a metal having high thermal conductivity, when a ground signal is applied, the cooling plate may operate as the third antenna element 333.

The third antenna element 333 is a component of a vehicle electronic device including a conductive material in addition to the heat sink, and may include a conductive material capable of electrical coupling with at least one of the first antenna element 331 or the second antenna element 332 when a ground signal is applied.

A second support member 530 may be further disposed between the third antenna element 333 and the PCB 510. One end of the second support member 530 may be in contact with the PCB 510, and the other end thereof may be in contact with the third antenna element 333. The second support member 530 may support the third antenna element 333 to maintain a predetermined distance from the second antenna element 332.

The second support member 530 may include an insulating material. When the third antenna element 333 also functions as a heat sink, the second support member 530 may include a thermal interface material (TIM) for well transferring heat generated from the PCB 510 to the third antenna element 333. For example, the second support member 530 may include at least one of thermal grease, thermal tape, thermal pad, or phase change material (PCM).

The chip module 540 may be further disposed on the first surface of the PCB 510. The chip module 540 may be the antenna module 320 that may be electrically connected to each of the first to third antenna elements 331, 332, and 333. However, the present disclosure is not limited thereto. The chip module 540 may include at least some components of the processor 210 or the communication module 220 described with reference to FIG. 1 or 2. Alternatively, the chip module 540 may be an antenna module electrically connected to an antenna element other than the first to third antenna elements 331, 332, and 333.

The chip module 540 may be disposed to overlap the third antenna element 333 in the thickness direction (e.g., z-axis direction) of the second antenna element 332. For example, the entire region of the chip module 540 may overlap the third antenna element 333 in the thickness direction of the second antenna element 332. That is, a partial region of the third antenna element 333 may overlap the second antenna element 332 in the thickness direction of the second antenna element 332, and the other partial region of the third antenna element 333 may overlap with the antenna module 320.

The third antenna element 333 may receive heat generated from the PCB 510 and/or the chip module 540 and disperse and release the heat to the outside regardless of whether an electrical signal is applied. One chip module 540 is illustrated in the drawing, but the present disclosure is not limited thereto. A plurality of chip modules 540 may be disposed. Alternatively, a module (e.g., sensor) that is included in a vehicle electronic device and generates heat may be disposed to overlap the third antenna element 333.

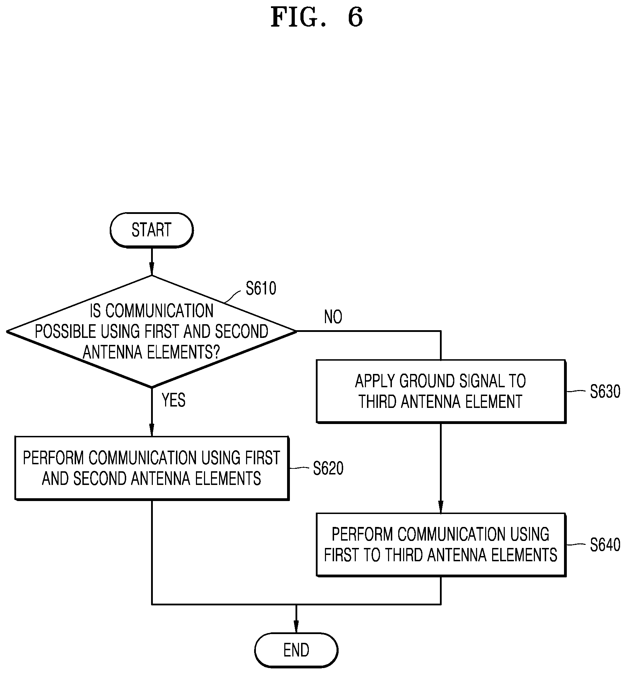

FIG. 6 is a flowchart illustrating a method of operating the antenna device 300 according to an embodiment.

The antenna module 320 may determine whether communication is possible using the first and second antenna elements 331 and 332 (S610). The antenna module 320 may apply a feed signal to the first antenna element 331 and apply a ground signal to the second antenna element 332, so that the first and second antenna elements 331 and 332 form a radiation pattern. When data transmission and reception are performed through the radiation pattern, the antenna module 320 may determine that communication is possible using the first and second antenna elements 331 and 332.

When it is determined that communication is possible using the first and second antenna elements 331 and 332 (S610-Yes), the antenna module 320 may perform communication using the first and second antenna elements 331 and 332 (S620). Specifically, the antenna module 320 may apply the feed signal to the first antenna element 331 and apply the ground signal to the second antenna element 332. On the other hand, the switching unit 323 may maintain an open state of an electrical signal between the ground unit 322 and the third antenna element 333. Then, the first antenna element 331 and the second antenna element 332 may be electrically coupled to generate a first directional radiation pattern. The first directional radiation pattern may have a maximum intensity at theta of 60 or more and 90 or less. The first directional radiation pattern may be a radiation pattern of a first frequency band. For example, a center frequency of the first frequency band may be included in a range of about 300 MHz to 5000 MHz.

The antenna module 320 may perform communication through a first network using the first and second antenna elements 331 and 332. The first network may be a terrestrial network. The terrestrial network is a network located on the surface of the Earth or a segment of the network, and may be a network through which wireless communication is possible through a base station installed on the ground.

When it is determined that communication is not possible using the first and second antenna elements 331 and 332 (S610-No), the antenna module 320 may apply a ground signal to the third antenna element 333 (S630). Specifically, for example, when data transmission and reception with an external device are not performed for a predetermined time using the first and second antenna elements 331 and 332, the antenna module 320 may determine that communication is impossible. Then, the switching unit 323 may electrically connect the ground unit 322 to the third antenna element 333 by the control of the antenna module 320.

Then, the antenna module 320 may perform communication using the first to third antenna elements 331, 332, and 333 (S640). Specifically, the antenna module 320 may apply a feed signal to the first antenna element 331, and apply a ground signal to the second and third antenna elements 332 and 333. Then, the first to third antenna elements 331, 332, and 333 may be electrically coupled to generate a second directional radiation pattern. The second directional radiation pattern may have a different directivity from the first directional radiation pattern. For example, the second directional radiation pattern may have a maximum intensity at theta of 0 to 30. The second directional radiation pattern may be a radiation pattern of a second frequency band. For example, a center frequency of the second frequency band may be included in a range of about 1 GHz to about 10 GHz.

The antenna module 320 may perform communication through a second network using the first to third antenna elements 331, 332, and 333. The second network may be a network different from the first network. A frequency band at which communication is possible in the second network may be different from a frequency band at which communication is possible in the first network. Alternatively, the second network may be an NTN. The NTN refers to a network or a network segment that uses RF resources mounted on a satellite (e.g., geostationary earth orbit (GEO) satellite, low-earth orbit (LEO) satellite, etc.) (or unmanned aircraft system (UAS) platform).

When communication through a terrestrial network is difficult using the first and second antenna elements 331 and 332, the antenna device 300 according to an embodiment performs communication through the NDN using the first to third antenna elements 331, 332, and 333, thereby reducing a white region of communication.

Because the directivity of the antenna device 300 according to an embodiment is changed according to whether the third antenna element 333 is used, the antenna device 300 may be referred to as a directional change antenna.

Because a conductive material disposed in the vehicle is used as the third antenna element 333, the number of antenna elements may be reduced, and the size of a vehicle electronic device may be prevented from increasing.

Because the directivity of the antenna device 300 according to an embodiment is changed according to whether the third antenna element 333 is used, the antenna device 300 may be referred to as a directional change antenna.

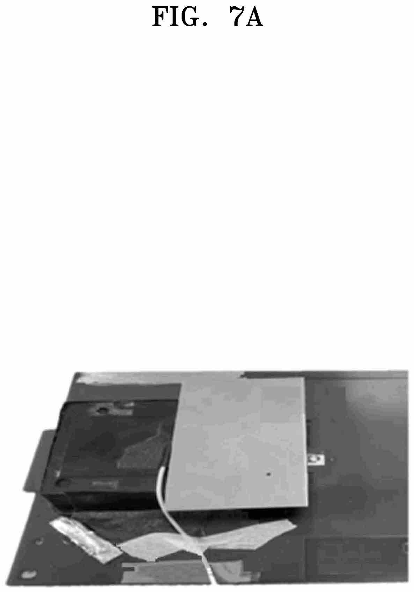

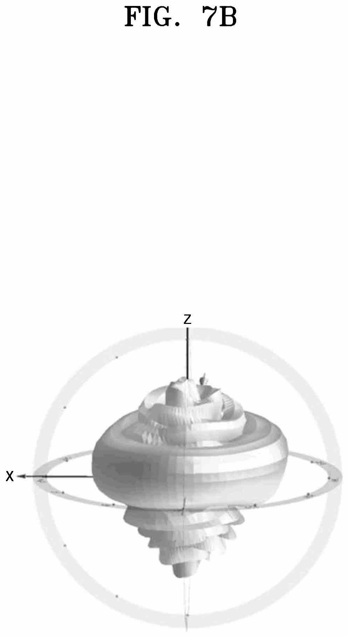

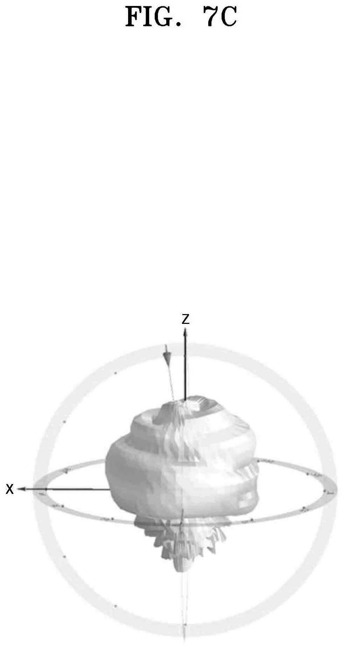

FIG. 7A is a photograph of a manufactured antenna device according to an embodiment. FIG. 7B illustrates results of simulating a radiation pattern when an electrical signal is not applied to the third antenna element 333 according to an embodiment. FIG. 7C illustrates results of simulating a radiation pattern when a ground signal is applied to the third antenna element 333.

As shown in FIG. 7A, a first antenna element and a second antenna element may be arranged parallel to each other on a PCB, and the third antenna element may be disposed to overlap the second antenna element. The third antenna element may be a vapor chamber including a conductive material. The third antenna element may be disposed so as not to overlap the first antenna element.

When the electrical signal is not applied to the third antenna element, it may be confirmed that the first and second antenna elements form a first directional radiation pattern, as shown in FIG. 7B. The first directional radiation pattern may have the greatest intensity at theta of 60 or more and 90 or less.

When the ground signal is applied to the third antenna element, as shown in FIG. 7C, it may be confirmed that the first to third antenna elements form a second directional radiation pattern. The third directional radiation pattern may have the greatest intensity at theta of 0 to 30.

As described above, an electronic device including antenna elements may generate a plurality of radiation patterns having different directivities by adjusting the number of grounded antenna elements. It has been described that the electronic device uses two antenna elements to generate a radiation pattern in which communication is possible through a terrestrial network and uses three antenna elements to generate a radiation pattern in which communication is possible through an NDN, but the present disclosure is not limited thereto. The directivity of a radiation pattern may vary depending on the shapes and sizes of the first to third antenna elements 331, 332, and 333, and thus, the antenna elements may be designed to generate a radiation pattern in which communication is possible through the NDN using two antenna elements and to generate a radiation pattern in which communication is possible through the terrestrial network using three antenna elements.

In addition, it has been described that the antenna module 320 determines whether communication is performed, but the present disclosure is not limited thereto. The processor 210 or the communication module 220 may determine whether communication is performed, and the processor 210 or the communication module 220 may directly control the switching unit 323.

The antenna device according to an embodiment may further include a support member maintaining a constant distance between antenna elements.

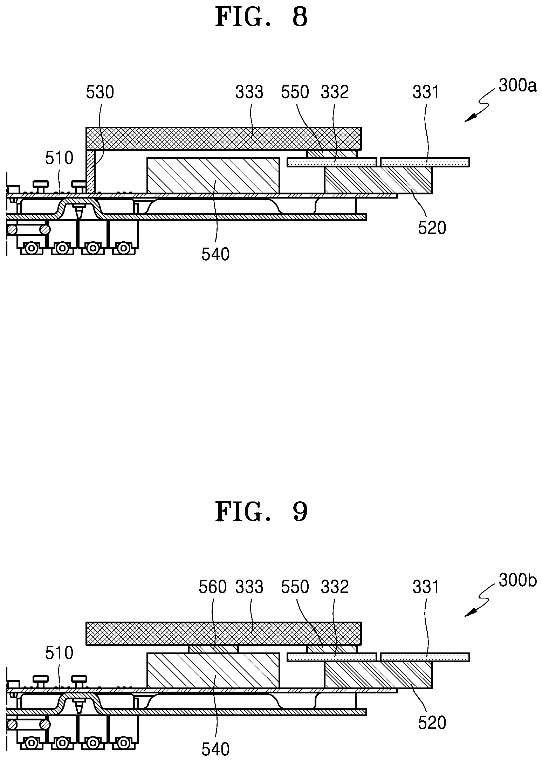

FIG. 8 is a diagram illustrating an antenna device 300a in which a third support member 550 is disposed between the second antenna element 332 and the third antenna element 333 according to an embodiment.

Upon comparing FIG. 5B with FIG. 8, in the antenna device 300a of FIG. 8, the third support member 550 may be disposed between the second antenna element 332 and the third antenna element 333. The third support member 550 may include an insulating material. The thickness of the third support member 550 may be 5 mm or less.

FIG. 9 is a diagram illustrating an antenna device 330b in which a fourth support member 560 is disposed between the chip module 540 and the third antenna element 333 according to an embodiment.

Upon comparing FIG. 8 with FIG. 9, in the antenna device 300b of FIG. 9, the fourth support member 560 may be disposed between the chip module 540 and the third antenna element 333. The fourth support member 560 may include an insulating material. The fourth support member 560 may include a TIM that transfers heat generated from the chip module 540 to the third antenna element 333. For example, the fourth support member 560 may include at least one of thermal grease, thermal tape, thermal pad, or PCM.

When the fourth support member 560 is disposed in FIG. 9, the second support member 530 shown in FIG. 5B may not be disposed. Alternatively, the third support member 550 and the fourth support member 560 of FIG. 9 may be formed as one support member.

An antenna device according to an embodiment may further include a dummy antenna element. Here, the dummy antenna element may be electrically coupled to an antenna element to which a feed signal is applied and/or an antenna element to which a ground signal is applied to form a radiation pattern, although the feed signal and the ground signal are not applied thereto.

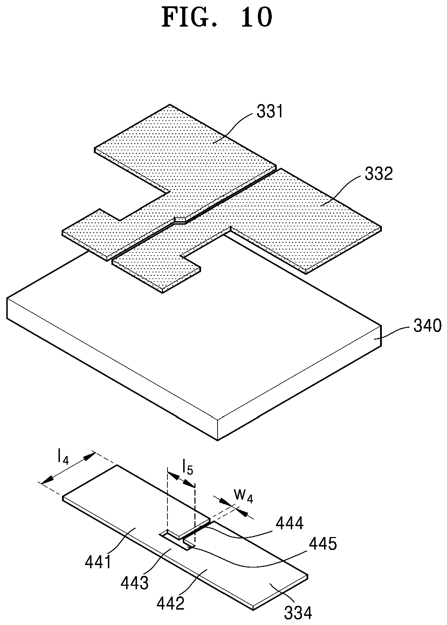

FIG. 10 is a diagram illustrating a part of an antenna device including a dummy antenna element 334 according to an embodiment.

Upon comparing FIG. 4 with FIG. 10, the antenna device of FIG. 10 may further include a substrate 340 supporting the first and second antenna elements 331 and 332 and the dummy antenna element 334 disposed on the substrate 340.

The substrate 340 may include a dielectric material. The thickness of the substrate 340 may be a thickness at which the dummy antenna element 334 may be coupled to the antenna element 20. For example, the thickness of the substrate 340 may be about 5 mm or less.

At least a part of the dummy antenna element 334 may overlap the first and second antenna elements 331 and 332 in a thickness direction of the substrate 340. In FIG. 1, the dummy antenna element 334 may be disposed to overlap the entire second regions 420a and 420b of the first and second antenna elements 331 and 332, may be disposed to overlap parts of the third regions 430a and 430b of the first and second antenna elements 331 and 332, and may be disposed not to overlap the first regions 410a and 410b of the first and second antenna elements 331 and 332. The degree of overlap between the dummy antenna element 334 and the first and second antenna elements 331 and 332 may be adjusted to alleviate a signal imbalance.

The dummy antenna element 334 may include a first dummy region 441 overlapping the first antenna element 331, a second dummy region 442 overlapping the second antenna element 332, and a third dummy region 443 disposed between the first dummy region 441 and the second dummy region 442. The first dummy region 441 may overlap the entire second region 420a of the first antenna element 331 in the thickness direction of the substrate 340, and the second dummy region 442 may overlap the entire second region 420b of the second antenna element 332 in the thickness direction of the substrate 340. However, the third dummy region 443 may not overlap any of the first region 410a of the first antenna element 331 and the first region 410b of the second antenna element 332.

The first dummy region 441 and the second dummy region 442 may also have a symmetrical structure with respect to the central axis X of the first and second antenna elements 331 and 332. The first and second dummy regions 441 and 442 may be completely symmetrical with respect to the central axis X, but may be referred to be symmetrical even when the similarity between the first dummy region 441 and the second dummy region 442 is 80 % or more.

The third dummy region 443 may be disposed between the first dummy region 441 and the second dummy region 442, one end thereof may be connected to the first dummy region 441, and the other end thereof may be connected to the second dummy region 442. The third dummy region 443 may connect the first and second dummy regions 441 and 442 to facilitate a current flow. The third dummy region 443 may be defined as a region that does not overlap the first and second antenna elements 331 and 332.

Meanwhile, the dummy antenna element 334 may further include one or more slots 444 and 445. For example, the dummy antenna element 334 may include the first slot 444 disposed on the central axis X to separate the first dummy region 441 and the second dummy region 442 and the second slot 445 disposed between the first slot 444 and the third dummy region 443.

One end of the first slot 444 may be opened at the edge of the dummy antenna element 334, and the other end of the first slot 444 may be connected to the second slot 445. A side end of the second slot 445 may be connected to the first slot 444, and both ends of the second slot 445 may be closed by the first and second dummy regions 441 and 442. The size of the second slot 445 may vary according to a resonance frequency.

Meanwhile, in order for the first and second antenna elements 331 and 332 to be smoothly coupled to the dummy antenna element 334, a separation distance between the second region 420a of the first antenna element 331 and the second region 420b of the second antenna element 332 may be greater than the separation distance d₁ between the third region 430a of the first antenna element 331 and the third region 430b of the second antenna element 332. Thus, current may flow from the second region 420a of the first antenna element 331 to the first dummy region 441 by coupling, and may flow to the second region 420b of the second antenna element 332 by coupling through the third dummy region 443 and the second dummy region 442.

The dummy antenna element 334 may smooth the current flow between the first antenna element 331 and the second antenna element 332 to alleviate the signal imbalance. Furthermore, the dummy antenna element 334 may be disposed to overlap the first and second antenna elements 331 and 332 on the substrate 340 to compactly implement the antenna device.

To alleviate the signal imbalance, the dummy antenna element 334 may further overlap the first and second antenna elements 331 and 332.

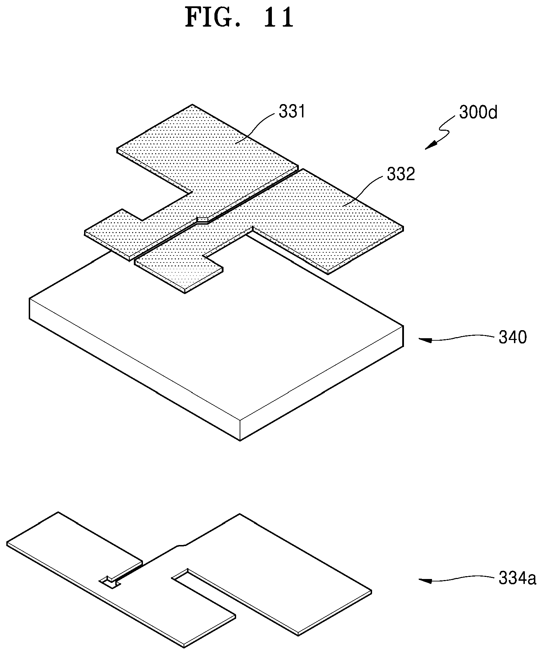

FIG. 11 is a diagram illustrating a part of an antenna device including a dummy antenna element according to an embodiment. Comparing FIG. 10 with FIG. 11, a dummy antenna element 334a shown in FIG. 11 may be disposed to entirely overlap the second antenna elements 332. Specifically, the dummy antenna element 334a may entirely overlap the second regions 420a of the first antenna element 331. The second dummy region 34a overlaps the entire second antenna element 332, and thus, a signal imbalance may be further alleviated.

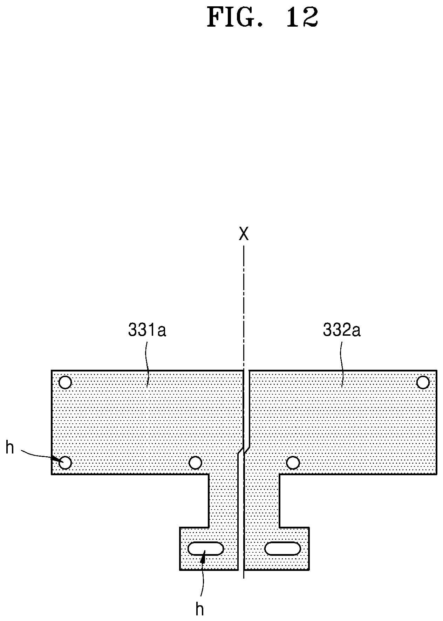

FIG. 12 is a view illustrating the first and second antenna elements 331a and 332a including holes h according to an embodiment. As shown in FIG. 12, the first and second antenna elements 331a and 332a may include the one or more holes h. The hole h may have a circular shape or an elliptical shape. However, the present disclosure is not limited thereto. The shape of the hole h may be polygonal, elliptical, circular, or a combination thereof. A signal imbalance may be mitigated by the hole h.

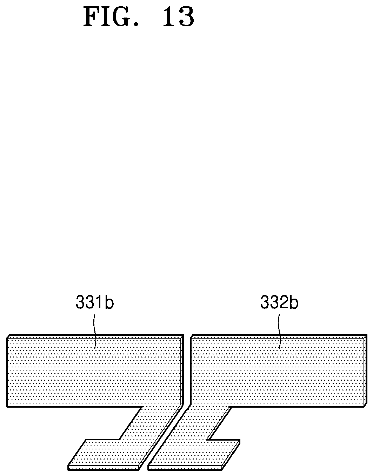

An antenna according to an embodiment may include a bent antenna element. FIG. 13 is a diagram illustrating bent antenna elements according to an embodiment. First and second antenna elements 331b and 332b may be bent one or more times. As shown in FIG. 13, among the first and second antenna elements 331b and 332b, the first regions 410a and 410b may be bent to be perpendicular to the third regions 430a and 430b. The overall dimensions of an antenna device may be adjusted due to bending of the first and second antenna elements 331b and 332b. In addition, communication performance may be improved due to bending of the antenna device.

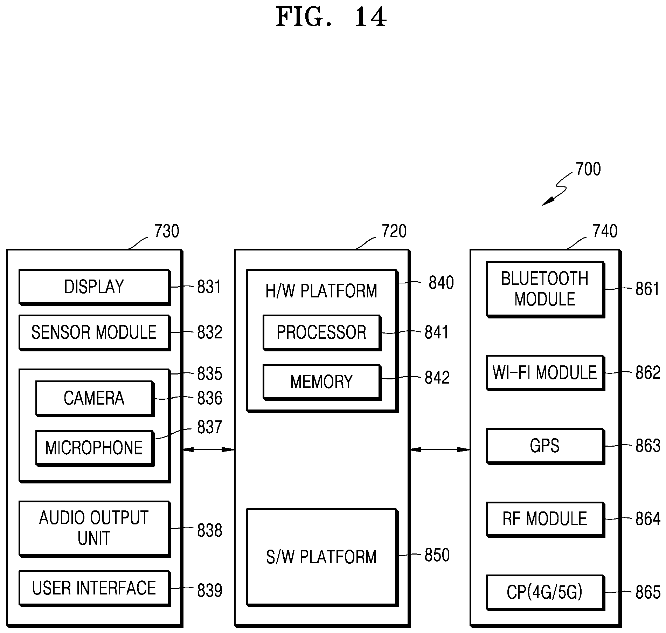

FIG. 14 is a block diagram illustrating a vehicle electronic device 700 including an antenna device according to an embodiment.

The vehicle electronic device 700 of FIG. 14 may include the vehicle antenna device 200 described with reference to FIG. 2. In addition, the vehicle electronic device 700 may refer to a computing device that is installable in the vehicle 100 with which the vehicle antenna device 300 is integrally formed.

Referring to FIG. 14, the vehicle electronic device 700 may include a processor 720, an input/output unit 730, and a communication unit 740. Specifically, the vehicle electronic device 700 may include a vehicle antenna device, and the vehicle antenna device may be integrally formed with the communication unit 740, which is a telematics control unit (TCU) performing communication in the vehicle 100.

In addition, the vehicle electronic device 700 may be an electronic device for implementing in-vehicle infotainment (IVI) technology. For example, the vehicle electronic device 700 may provide service, information, and/or content customized to a specific user based on user location information. Specifically, the vehicle electronic device 700 may perform communication between the vehicle 100 and an external device to obtain information required to operate or use the vehicle 100. Alternatively, the vehicle electronic device 700 may perform communication between the vehicle 100 and the external device to provide service, information, and/or content to a user.

The processor 720 and the input/output unit 730 included in the vehicle electronic device 700 may be collectively referred to as an IVI head unit. In addition, the vehicle electronic device 700 may be disposed in the middle of a central front portion of the vehicle 100 between a driver's seat and a passenger seat. In this case, an antenna element included in the vehicle electronic device 700 may be provided at a position spaced apart from other components included in the vehicle electronic device 700, and the antenna element may be connected to other components of the vehicle electronic device 700 through a wired communication interface such as a wired cable or through a wireless communication interface.

In addition, the communication unit 740 may be referred to as a TCU.

The TCU is a component for controlling data transmission and reception in the vehicle 100, and may be responsible for communication between the vehicle 100 and an external device (e.g., a server or a mobile device).

The processor 720 may include components (e.g., an Application processor AP and memory) for implementing a hardware (H/W) platform 840 and components (e.g., an OS program, automotive safety software, and an application) for implementing a software (S/W) platform 850.

Specifically, the components for implementing the H/W platform 840 may include at least one Application processor AP and memory 842. Here, an example in which the memory 842 is included in the H/W platform 840 has been described. In addition, the memory 842 may be included in the vehicle electronic device 700 as a separate component rather than being included in the H/W platform 840.

In addition, the components for implementing the H/W platform 840 may further include a universal serial bus (USB) module (not shown) and an FM/DMB tuner (not shown). Here, the USB module (not shown) may include a USB insertion unit (not shown) to read data in an inserted USB. In addition, the FM/DMB tuner (not shown) may selectively receive an FM/DMB broadcasting signal. Specifically, the FM/DMB tuner (not shown) may tune and select only a frequency of a channel desired to be received by the vehicle electronic device 700 from among a lot of electromagnetic wave components through amplification, mixing, and resonance performed on a wirelessly received broadcasting signal. The broadcasting signal received by the FM/DMB tuner (not shown) may include audio, video, and additional information (e.g., an electronic program guide (EPG)).

The components for implementing S/W platform 850 may include an OS program, automotive safety software, and an application. Here, the OS program may include a QNX, Linux, or Android-based OS program.

The input/output unit 730 is a component for providing data to a user or receiving a request of the user, and may include at least one of a display 831, a sensor module 832, a camera module 835, an audio output unit 838, or a user interface 839.

The sensor module 832 may detect an operating state (power, temperature, etc.) of the vehicle electronic device 700 or an external environmental state (user state, etc.), and generate an electrical signal and/or data value corresponding to the detected state. The sensor module 832 may include a gyro sensor, an atmospheric pressure sensor, a magnetic sensor, an acceleration sensor, a proximity sensor, a color sensor, an infrared (IR) sensor, a biometric sensor, a temperature sensor, a humidity sensor, and/or an illuminance sensor.

The camera module 835 is a component for obtaining image and/or voice data, and may include a camera 836 and a microphone 837. In addition, the camera module 835 may include a speaker (not shown) to output an operating sound of the camera 836. In addition, when the camera module 835 does not include a separate speaker (not shown), the operating sound of the camera 836 may be output through the audio output unit 838.

For example, the camera module 835 may operate as a detection sensor for recognizing a user's gesture and voice

Specifically, the camera 836 may receive an image (e.g., consecutive frames) corresponding to a user's motion including a gesture within a camera recognition range. For example, the recognition range of the camera 836 may be a distance of 0.1 m to 5 m from the camera 836 to the user. The user's motion may include, for example, the user's face, facial expression, a body part of the user such as a hand, a fist, or a finger, or a motion of the body part of the user. The camera 836 may recognize a received image by converting the received image into an electrical signal by the control of the processor 720, and may select a menu displayed on the vehicle electronic device 700 by using a recognition result corresponding to the user's motion or may perform control corresponding to the motion recognition result. For example, the processor 720 may control channel selection, channel change, volume adjustment, and execution of available services in FM/DMB by using the recognition result obtained by the camera 836.

The camera 836 may be implemented as an integral type with or a separate type from the vehicle electronic device 700. The separate-type camera 836 may be electrically connected to the antenna module 320 of the vehicle electronic device 700 through the communication unit 740 or the input/output unit 730. For example, when the camera 836 is implemented as a separate type from the vehicle electronic device 700, the camera 836 may be disposed at a position corresponding to a driver's face and front upper body to capture an image of the driver's face and upper body.

The microphone 837 may receive an audio signal such as a voice signal. The microphone 837 may receive the user's voice signal, and the processor 720 may recognize a control command corresponding to the voice received by the microphone 837 and may control a corresponding operation to be executed. In addition, the microphone 837 may be included in the vehicle electronic device 700 as a separate module, rather than being included in the camera module 835.

The user interface 839 may receive a user input for controlling the vehicle electronic device 700. The user interface 839 may include a push button, a wheel, a keyboard, a jog dial, a touch panel, and a haptic sensor for receiving the user's input.

The communication unit 740 may include the at least one antenna device 300 for performing wireless communication. Specifically, the communication unit 740 may include at least one of a Bluetooth module 861, a Wi-Fi module 862, a global positioning system (GPS) module 863, an RF module 864, or a communication processor (CP) module 865. Here, the CP module 865 is a modem chipset, and may perform communication with an external electronic device through a communication network according to the 3G, 4G, 5G, or 6G communication standard. In addition, the communication unit 740 may further include the at least one antenna device 300 that performs communication according to the communication standard such as Bluetooth low energy (BLE), near-field communication (NFC)/radio frequency identification (RFID), Wi-Fi direct, ultra-wideband (UWB), and/or Zigbee.

The antenna device 300 according to an embodiment may be one component included in the communication unit 740. For example, the antenna device 300 according to an embodiment may be included in the CP module 865. An antenna element of the antenna device 300 according to an embodiment may be included in the CP module 865, some functions of the antenna module 320 of the antenna device 300 according to an embodiment may be included in the CP module 865, and the remaining functions of the antenna module 320 may be included in the processor 720.

In addition, the components included in the vehicle electronic device 700, for example, the antenna module 320, the input/output unit 730, and the communication unit 740, may communicate with each other through a vehicle network. In addition, the vehicle electronic device 700 and other components included in the vehicle 100 may communicate with each other through the vehicle network. Here, the vehicle network may be a network according to a controller area network (CAN) and/or media oriented systems transport (MOST).

The operating method of the vehicle electronic device and the control method of the vehicle antenna device according to the disclosed embodiment may be implemented in the form of program commands that may be executed through various computer means and recorded on a computer-readable medium. In addition, the embodiment of the present disclosure may be a computer-readable recording medium storing thereon one or more programs including instructions executing the control method of the vehicle antenna device.

The computer-readable medium may include a program command, a data file, a data structure, etc. alone or in combination. Program commands recorded on the medium may be specially designed and configured for the present disclosure or may be known to and used by one of ordinary skill in computer software. Examples of computer-readable recording medium include magnetic media such as hard disk, floppy disk and magnetic tape, optical media such as CD-ROM and DVD, magnetic-optical media such as floptical disk, and hardware devices specifically configured to store and execute program instructions such as ROM, RAM, and flash memory. Examples of program instructions include machine language codes, such as those made by a compiler, as well as advanced language codes that may be executed by a computer using an interpreter.

The machine-readable storage medium may be provided in the shape of a non-transitory storage medium. Here, the 'non-transitory storage medium' only denotes a tangible device and does not include a signal (e.g., electromagnetic waves). This term does not distinguish a case where data is stored in the storage medium semi-permanently and a case where the data is stored in the storage medium temporarily. For example, the 'non-transitory storage medium' may include a buffer where data is temporarily store.

According to an embodiment, the control method of the vehicle antenna device 300 and the operating method of the vehicle antenna device 300 according to various embodiments of the disclosure in the specification may be provided by being included in a computer program product. The computer program product, which is a commodity, may be traded between sellers and buyers. The computer program product may be distributed in the shape of machine-readable storage medium (e.g., compact disc read only memory (CD-ROM)), or distributed (e.g., downloaded or uploaded) through an application store (e.g. PlayStore TM) or directly and online between two user devices (e.g., smartphones). In the case of online distribution, at least a part of the computer program product (e.g., a downloadable app) may be at least temporarily generated or temporarily stored in a machine-readable storage medium, such as a server of a manufacturer, a server of an application store, or memory of a relay server.

Specifically, a computer program product including a recording medium storing a program for performing the control method of the vehicle antenna device and the operating method of the vehicle antenna device according to the disclosed embodiment may be implemented.

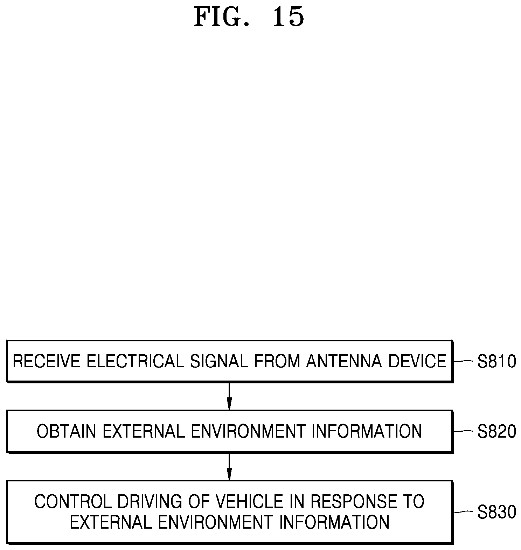

FIG. 15 is a flowchart illustrating a method of controlling driving of a vehicle by using an antenna device according to an embodiment. Referring to FIG. 15, the processor 210 may receive an electrical signal from the antenna device (S810). As described with reference to FIG. 6, the antenna devices 300, 300a, and 300b may communicate using the first antenna element 331 and the second antenna element 332, or communicate using the first antenna element 331, the second antenna element 332, and the third antenna element 333 to transmit an electrical signal to the processor 210. A method for the antenna device 300 to perform communication has been described above, and thus, a detailed description thereof is omitted.

The processor 210 may obtain environment information from the electrical signal received from the antenna (S820). The environment information may include traffic volume information, construction information, accident information, weather information, external object information, etc.

The processor 210 may control driving of the vehicle in response to the environment information (S830). The processor 210 may control a driver to change at least one of a driving path and a driving speed of the vehicle in response to the environment information. Although the driver is not shown, the driver may include a steering control unit and a speed control unit. A vehicle control manual matching the environment information may be pre-stored in memory (not shown). The processor 210 may read the vehicle control manual matching the environment information from the memory and may control driving of the vehicle. However, the present disclosure is not limited thereto. The processor 210 may control driving of the vehicle corresponding to the environment information by using a learning network model of an artificial intelligence (AI) system. For example, the processor 210 may control driving of the vehicle in order to prevent collision with an accident vehicle.

It has been described that the antenna according to an embodiment is installed in the vehicle, but the present disclosure is not limited thereto. The antenna may be installed in a device that requires communication with different directivities.

A vehicle antenna device or a directional variable antenna device according to an embodiment may include the patch-type first antenna element 331 to which a feed signal is applied.

The vehicle antenna device or the directional variable antenna device according to an embodiment may include the patch-type second antenna element 332 to which a ground signal is applied, and spaced apart from the first antenna element 331.

The vehicle antenna device or the directional variable antenna device according to an embodiment may include the third antenna element 333 spaced apart from the first and second antenna elements 331 and 332.

The vehicle antenna device or the directional variable antenna device according to an embodiment may form a first directional radiation pattern when an electrical signal is not applied to the third antenna element 333.

The vehicle antenna device or the directional variable antenna device according to an embodiment may form a second directional radiation pattern different from the first directional radiation pattern when a ground signal is applied to the third antenna element 333.

The vehicle antenna device or the directional variable antenna device according to an embodiment may include the ground unit 322 configured to apply the ground signal to at least one of the second antenna element 332 or the third antenna element 333.

The vehicle antenna device or the directional variable antenna device according to an embodiment may include the switching unit 323 configured to turn on or off an electrical connection between the ground unit 322 and the third antenna element 333.

Any one of the first directional radiation pattern and the second directional radiation pattern may have has a maximum intensity at theta of 60 or more and 90 or less, and

The other one of the first directional radiation pattern and the second directional radiation pattern may have a maximum intensity at theta of 0 or more and 30 or less.

The vehicle antenna device or the directional variable antenna device according to an embodiment may perform communication through a first network using the first directional radiation pattern.

The vehicle antenna device or the directional variable antenna device according to an embodiment may perform communication through a second network different from the first network using the second directional radiation pattern.

Any one of the first and second networks may be a terrestrial network.

The other one of the first and second networks may be an NDN.

A center frequency of the first directional radiation pattern and a center frequency of the second directional radiation pattern may be different from each other.

The center frequency of the first directional radiation pattern may be smaller than the center frequency of the second directional radiation pattern.

The first directional radiation pattern may be formed through electrical coupling of the first and second antenna elements 331 and 332.

The second directional radiation pattern may be formed through electrical coupling of the first to third antenna elements 331 to 333.

The first and second antenna elements 331 and 332 may be arranged in parallel in a direction perpendicular to a thickness direction of the second antenna element 332.

The second and third antenna elements 332 and 333 may be arranged in parallel in the thickness direction of the second antenna element 332.

The first antenna element 331 may not overlap the third antenna element 333 in the thickness direction of the second antenna element 332.

The second antenna element 332 may overlap the third antenna element 333 in the thickness direction of the second antenna element 332.

More than half of the second antenna element 332 may overlap the third antenna element 333 in the thickness direction of the second antenna element 332.

The third antenna element 333 may be a heat sink that disperses or releases heat generated from a vehicle.

The vehicle antenna device or the directional variable antenna device according to an embodiment may include the PCB 510.

The vehicle antenna device or the directional variable antenna device according to an embodiment may include the chip module 540 disposed on the PCB 510.

The third antenna element 333 may overlap the chip module 540 in a thickness direction of the PCB 510.

The chip module 540 may entirely overlap the third antenna element 333 in the thickness direction of the PCB 510.

The chip module 540 may be connected to the third antenna element 333 using a TIM.

An operating method of a vehicle antenna device or a directional variable antenna device including the first antenna element 331, the second antenna element 332, and the third antenna element 333 according to an embodiment may include performing communication through a first network by applying a feed signal to the first antenna element 331 and applying a ground signal to the second antenna element 332.

The operating method of the vehicle antenna device or the directional variable antenna device including the first antenna element 331, the second antenna element 332, and the third antenna element 333 according to an embodiment may include performing communication through a second network by applying a feed signal to the first antenna element 331 and a ground signal to the second antenna element 332 and the third antenna element 333 when communication through the first network is impossible.

Any one of the first and second networks may be a terrestrial network.

The other one of the first and second networks may be an NDN.

Although embodiments of the present disclosure have been described above in detail, the scope of the present disclosure is not limited thereto, and various modifications and alterations by one of skill in the art using the basic concept of the present disclosure defined in the following claims also fall within the scope of the present disclosure.

## Claims

1. A directional variable antenna device (300) comprising:
a patch-type first antenna element (331) to which a feed signal is applied; a patch-type second antenna element (332) to which a ground signal is applied, and spaced apart from the first antenna element (331); and
a third antenna element (333) spaced apart from the first and second antenna elements (331) and (332),
wherein the directional variable antenna device (300) is configured to form a first directional radiation pattern when an electrical signal is not applied to the third antenna element (333), and
form a second directional radiation pattern different from the first directional radiation pattern when a ground signal is applied to the third antenna element (333).

2. The directional variable antenna device of claim 1, further comprising:
a ground unit (322) configured to apply the ground signal to at least one of the second antenna element (332) or the third antenna element (333); and
a switching unit (323) configured to turn on or off an electrical connection between the ground unit (322) and the third antenna element (333),
wherein the switching unit (323) includes at least one of an inductor or a capacitor.

3. The directional variable antenna device of claim 1 or 2, wherein
any one of the first directional radiation pattern and the second directional radiation pattern has
a maximum intensity at theta of 60 or more and 90 or less, and
the other one of the first directional radiation pattern and the second directional radiation pattern has
a maximum intensity at theta of 0 or more and 30 or less.

4. The directional variable antenna device of claims 1 to 3, wherein
the directional variable antenna device is configured to
perform communication through a first network using the first directional radiation pattern, and
perform communication through a second network different from the first network using the second directional radiation pattern.

5. The directional variable antenna device of any one of claims 1 to 4, wherein
a center frequency of the first directional radiation pattern and a center frequency of the second directional radiation pattern are different from each other.

6. The directional variable antenna device of any one of claims 1 to 5, wherein
the first directional radiation pattern is formed through electrical coupling of the first and second antenna elements (331) and (332), and
the second directional radiation pattern is formed through electrical coupling of the first to third antenna elements (331) to (333).

7. The directional variable antenna device of any one of claims 1 to 6, wherein
the first and second antenna elements (331) and (332) are
arranged in parallel in a direction perpendicular to a thickness direction of the second antenna element (332).

8. The directional variable antenna device of any one of claims 1 to 7,
wherein
the second and third antenna elements (332) and (333) are
arranged in parallel in the thickness direction of the second antenna element (332).

9. The directional variable antenna device of any one of claims 1 to 8, wherein
the first antenna element (331)
does not overlap the third antenna element (333) in the thickness direction of the second antenna element (332).

10. The directional variable antenna device of any one of claims 1 to 9, wherein
more than half of the second antenna element (332)
overlaps the third antenna element (333) in the thickness direction of the second antenna element (332).

11. The directional variable antenna device of any one of claims 1 to 10, wherein
the third antenna element (333) is
a heat sink that disperses or releases heat generated from a vehicle.

12. The directional variable antenna device of any one of claims 1 to 11, further comprising:
a printed circuit board (510); and
a chip module (540) disposed on the printed circuit board (510),
wherein the third antenna element (333) overlaps the chip module (540) in a thickness direction of the printed circuit board (510).

13. The directional variable antenna device of claim 12, wherein
the chip module (540) entirely
overlaps the third antenna element (333) in the thickness direction of the printed circuit board (510).

14. The directional variable antenna device of claim 12, wherein
the chip module (540) is
connected to the third antenna element (333) using a thermal interface material (TIM).

15. An operating method of a directional variable antenna device comprising a first antenna element (331), a second antenna element (332), and a third antenna element (333), the operating method comprising:
performing communication through a first network by applying a feed signal to the first antenna element (331) and applying a ground signal to the second antenna element (332); and
performing communication through a second network by applying a feed signal to the first antenna element (331) and a ground signal to the second antenna element (332) and the third antenna element (333) when communication through the first network is impossible.
